# EUROPÄISCHE PATENTSCHRIFT

(11) **EP 0 733 951 B1**
(45) Veröffentlichungstag und Bekanntmachung des Hinweises auf die Patenterteilung: **02.09.1998**
(21) Anmeldenummer: 96101052.7
(22) Anmeldetag: 25.01.1996
(51) Int. Cl.: G03F 1/00, G03F 7/12

(54) **Verfahren und Vorrichtung zur Herstellung einer Druckschablone**
Process and apparatus for the fabrication of a printing screen
Procédé et appareil pour la fabrication d'un écran sérigraphique

(30) Priorität: 26.01.1995 CH 213/95
(43) Veröffentlichungstag der Anmeldung: 25.09.1996
(73) Patentinhaber: Lüscher, Ursula, 5616 Meisterschwanden (CH); Lüscher, Hans, 5600 Lenzburg (CH)
(72) Erfinder: Berner, Peter, CH-5102 Rupperswil (CH)
(74) Vertreter: EGLI-EUROPEAN PATENT ATTORNEYS

(56) Entgegenhaltungen:
- EP-A- 0 492 351
- EP-A- 0 554 505
- EP-A- 0 562 150
- EP-A- 0 598 926
- EP-A- 0 622 190
- DE-A- 4 211 262
- US-A- 4 390 369
- US-A- 5 154 121
- US-A- 5 192 641

## Beschreibung

Die vorliegende Erfindung betrifft ein Verfahren und eine Vorrichtung zur Herstellung einer Druckschablone mit einem feinmaschigen Sieb, das mit einer unbelichteten Photoemulsionsschicht versehen ist und auf dem diejenigen Stellen, die nicht zu belichten sind, musterbedingt mit einer lichtundurchlässigen Schicht abgedeckt werden, wobei die Deckschicht Wachs enthält und nach der Belichtung entfernt wird.

Solcherart beschichtete Druckschablonen sind bekannt, wie die EP-A-0 492 351, die EP-A-0 558 098 oder die EP-A-0 590 164 zeigen. Einzeln betrachtet wird bei der EP-A-0 492 351 ein Verfahren und eine entsprechende Vorrichtung zur Herstellung einer artgemässen Druckschablone vorgeschlagen. Vorzugsweise wird dabei ein Pulver, wie z.B. Talkpulver auf das Sieb gegeben, damit die danach aufgespritzte Tinte nicht verfliesst, sondern genaue Konturen bildet. Als nachteilig an dieser Anordnung kann die Verwendung des Pulvers betrachtet werden, das immer einen Nebel am Arbeitsplatz bildet und damit die Umgebung beeinträchtigt.

In der EP-A-0 558 098 wird die Ausbildung von Reitstöcken beschrieben, die mit Absätzen versehen sind, um rohrförmige Siebe mit unterschiedlichen Durchmessern zentrieren zu können. Die Herstellung solcher Reitstöcke ist relativ aufwendig und daher teuer, da im Vergleich mit einfachen, bekannten Reitstöcken nur diese auszuwechseln wären, tritt die Verteuerung erkennbar in den Vordergrund.

Schliesslich zeigt die EP-A-0 590 164 ein Verfahren, bei dem die Abdeckschicht aus einer zähviskosen Schicht gebildet wird. Als Material für diese zähviskose Schicht wird eine Emulsion eines Kunstharzlackes vorgeschlagen. Ein solches Material hat jedoch eine grosse Haftungskraft auf dem Sieb, ein Auswaschen nach dem Belichten ist nicht vorgesehen, denn die Abdeckflüssigkeit soll resistent gegen Abrasion und gegen chemische Einflüsse der Druckchemikalien sein.

Dementsprechend ist es eine Aufgabe der Erfindung ein Verfahren bzw. eine Vorrichtung anzugeben, nach welchem bzw. mit welcher eine leicht entfernbare Deckschicht mustergenau auf ein Sieb aufbringbar ist, und das Sieb als Rohr oder als ebene Fläche beschichtbar ist.

Erfindungsgemäss wird dies nach den Merkmalen in den Ansprüchen 1 und 5 erreicht, wobei das Verfahren dadurch gekennzeichnet ist, dass die Wachs enthaltende Deckschicht mittels eines Sprühkopfes in Bändern auf die Photoemulsionsschicht aufgebracht wird. Weiterbildungen des erfindungsgemässen Verfahrens umfassen bei einem zylindrischen bzw. rohrförmigen Sieb die gesetzmässige Variation der jeweiligen Anfänge der bandförmigen Deckschicht für eine Umdrehung des Siebes, welche vorzugsweise einer Sinuslinie folgt bzw. das der Beschichtung im gleichen Arbeitsgang nachfolgende Belichten der nicht durch das Wachs abgedeckten Stellen des mit einer bandförmigen Deckschicht beschichteten rohrförmigen oder flachen Siebes.

Die Vorrichtung ist gekennzeichnet dadurch, dass der Beschichter einen Sprühkopf zum Aufbringen der Wachs enthaltenden Deckschicht in Bändern auf die Photoemulsionsschicht umfasst. Weiterbildungen der erfindungsgemässen Vorrichtung umfassen wenigstens einen Reitstock einer Anordnung zum Rotieren eines rohrförmigen Siebes um seine Längsachse, welcher mit einer Zuführung von Pressluft in den zylindrischen Hohlraum des rohrförmigen Siebes ausgebildet ist, wobei die Vorrichtung vorzugsweise eine Anzahl Stützen mit je einer Auflageplatte und je einer kreissegmentförmiger Ausnehmung umfasst.

Zur Halterung eines flachen Siebes weist die erfindungsgemässe Vorrichtung bzw. die Vorrichtung zur Durchführung des Verfahrens eine Anzahl zeilen- und spaltenförmig angeordneter Stützköpfe auf, wobei vorzugsweise einige der Stützköpfe so ausgebildet und angeordnet sind, dass sie auch die Ausrichtung des Rahmens des flachen Siebes in den zwei Hauptrichtungen X- und Y- bewirken.

Nachfolgend werden Ausführungsbeispiele der Erfindung an Hand der Zeichnungen erläutert. Es zeigen:
- Fig. 1: einen Aufriss einer Vorrichtung zum Beschichten eines zylindrischen Siebes mit Mitteln zum Aufspannen desselben;
- Fig. 2: einen Seitenriss von links in Fig. 1 gesehen;
- Fig. 3: eine Draufsicht auf den Schlitten mit der Spritzdüsenanordnung und den zugehörigen Steuerungsmitteln;
- Fig. 4: einen Seitenriss einer Vorrichtung zum Beschichten eines ebenen Siebes; und
- Fig. 5: eine Vorderansicht der Halterung des Einspannrahmens des Siebes.

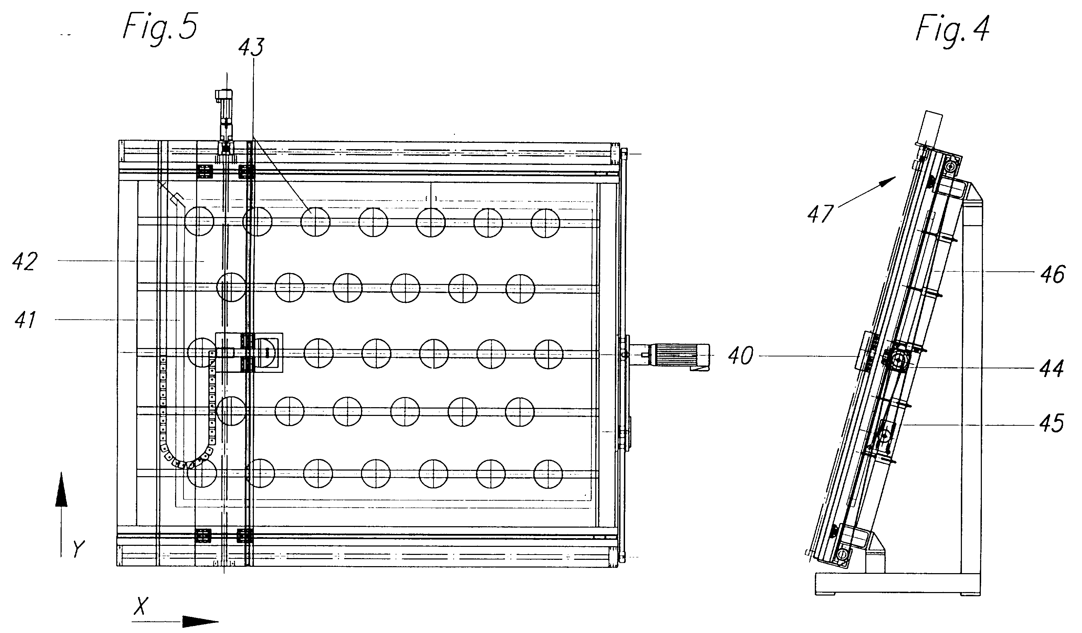

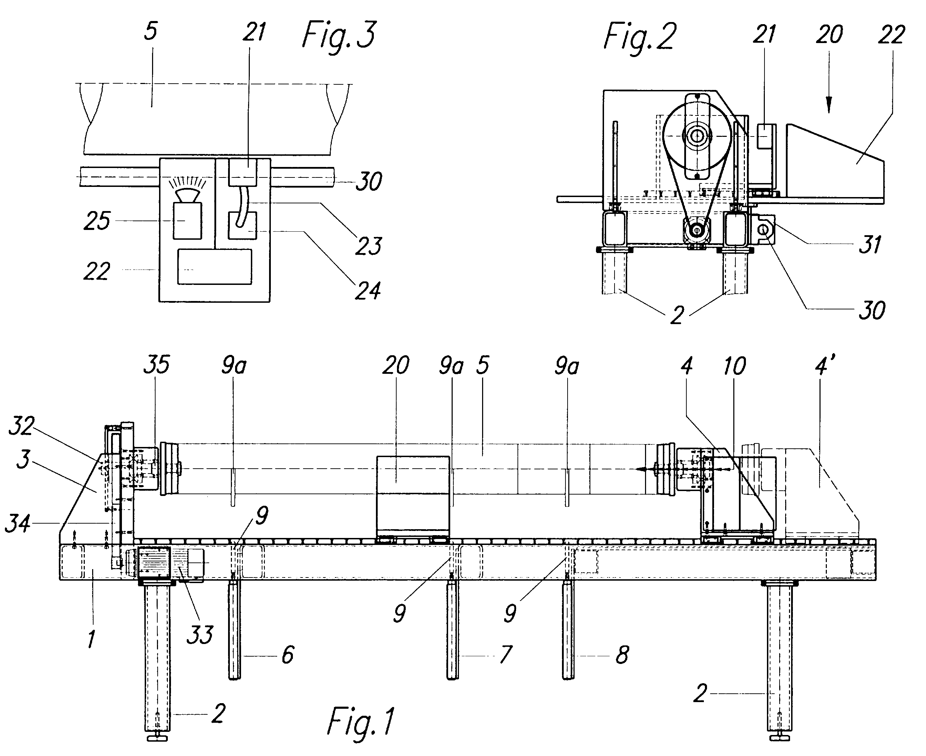

Die Anordnung zur Beschichtung eines zylindrischen Siebes gemäss Fig. 1, 2 und 3 zeigt ein Gestell 1 auf Stützen 2, von denen zwei in Fig. 1 ersichtlich sind. Zwei Reitstöcke 3,4 dienen in bekannter Weise zum Einspannen des zylinderförmigen Siebes 5 und zu dessen Antrieb mittels eines Motors 33 und einem Zahnriemen 34 auf die Spindel 35 im Reitstock 3. Wie durch die mit unterbrochenen Linien dargestellte Lage des Reitstockes 4 als Reitstock 4' gezeigt ist, ist dieser Reitstock 4 axial verschieblich angeordnet, um das Sieb ungehindert von oben oder von vorn einlegen zu können. Als Einlegehilfe dienen beispielsweise drei vertikal einstellbare Stützen 6,7,8 die je ein mit einer kreissegmentförmigen Ausnehmung mit dem Radius des Siebes 5 versehene Auflageplatte 9 aufweisen. Diese Stützen 6,7,8 werden mechanisch oder pneumatisch hochgefahren, so dass die Auflageplatten in die Stellung 9a kommen und damit ein Bett für das Sieb 5 bilden. Nach dem Einfahren des Reitstockes 4 in die Haltelage wird das Sieb 5 zentriert und mittels eines Gebläses 10 wird Luft in das Sieb geblasen, so dass dieses die korrekte kreiszylindrische Form einnimmt.

Der Beschichter 20 ist in Fig.2 und 3 ersichtlich im vorliegenden Fall besteht er aus einem Sprühkopf 21 der bis zu 96 Düsen aufweisen kann, die unter einem spitzen Winkel zur Basis des Beschichters linienartig angeordnet sind. Auf dem Beschichter 20 befinden sich ausserdem die Steuerung 22 mit einem Datengeber, durch den die einzelnen Düsen des Sprühkopfes 21 gesteuert werden, d.h. geschlossen oder geöffnet werden. Auf dem Beschichter 20 befindet sich selbstverständlich auch das Reservoir 24 für die Beschichtungsflüssigkeit, im vorliegenden Falle mit Leim vermischtes Wachs, das somit erwärmt und mittels wärmegeschützter Leitung 23 dem Sprühkopf 21 zugeleitet wird.

Die Beschichtung mit einem Sprühkopf 21 mit beispielsweise 96 Düsen erfolgt in Bändern mit etwa 8 mm Breite. Ein Antrieb mit einem Schrittgetriebe kann somit jeweils nach einer einzigen Umdrehung des Siebes um 8 mm vorgeschoben werden. Der Anfangspunkt für eine Umdrehung wird durch einen Stellungsgeber 32 bestimmt.

Ein Lichtstrahler 25 kann ebenfalls auf den Beschichter 20 montiert sein, so dass grundsätzlich die Belichtung der nicht durch das Wachs abgedeckte Stellen im gleichen Arbeitsgang erfolgen kann.

Der Vorschub des Beschichters erfolgt mittels einer Spindel 30, und mittels einer Kugelschraubenmutter 31 und damit in sehr gleichmässiger Form.

Es ist leicht einzusehen, dass eine Beschichtung die immer an derselben Stelle des Umfanges des zylindrischen Siebes ihren Ursprung hat eine Linie im Muster erzeugen kann. Um das zu beheben wird der für die Steuerung notwendige Winkelgeber 32 benützt, um die Einstellung des Beschichters 40 bezüglich des Ursprungs des Musters in an sich beliebiger Weise zu verstellen. Vorteilhafterweise kann diese Verstellung mit einer Sinusfunktion um den Ursprung herum geschehen. Damit wird der jeweilige Anfang für eine Umdrehung des Siebes vor- oder zurückverschoben und es kann sich keine erkennbare unterbrechung im Muster ergeben.

In ähnlicher Weise wird auch der Beschichter 40 über das flache Sieb bewegt. Nur dass hier der Beschichter 40 in zwei orthogonalen Richtungen bewegt wird. Zur korrekten Halterung des ebenen, in einen Rahmen 41 eingespannten Siebes 42 dienen Stützköpfe 43, an die der Rahmen 41 in zwei orthogonalen Richtungen anliegt und so eine genau fixierbare Lage hat. Das Sieb 42 liegt an mehreren Stellen auf weiteren Stützköpfen 43 auf und kann dadurch dem leichten Druck des Beschichters 40 widerstehen. Für den Antrieb in Y-Richtung (siehe Fig.5) dient ein Motor 44, der über ein mit Spannelementen 45 gespanntes Antriebsband 46 einen Schlitten 47 mit dem Beschichter 40 schrittweise verschiebt. In X-Richtung wird dann der Beschichter 40 gleichmässig, mit an sich bekannten Antriebsmitteln, hin und herbewegt. Es ist dabei nicht wichtig, ob der Beschichter in beiden Verschieberichtungen das Sieb besprüht oder nur in einer Richtung, wenn man bedenkt, dass die jeweilige Beschichtungsbreite von 8 mm mit den 96 Düsen vor der nachfolgenden Beschichtung vorgeschoben werden muss, könnte ebensogut mit einem raschen Rücklauf wieder an derselben Randstelle des Rahmens beschichtet werden.

## Patentansprüche

1. Verfahren zur Herstellung einer Druckschablone mit einem feinmaschigen Sieb, das mit einer unbelichteten Photoemulsionsschicht versehen ist und auf dem diejenigen Stellen, die nicht zu belichten sind, musterbedingt mit einer lichtundurchlässigen Schicht abgedeckt werden, wobei die Deckschicht Wachs enthält und nach der Belichtung entfernt wird, **dadurch gekennzeichnet, dass** die Deckschicht mittels eines Sprühkopfes in Bändern auf die Photoemulsionsschicht aufgebracht wird.

2. Verfahren nach Anspruch 1, **dadurch gekennzeichnet, dass** bei einem zylindrischen bzw. rohrförmigen Sieb (5) die jeweiligen Anfänge der bandförmigen Deckschicht für eine Umdrehung des Siebes gesetzmässig variiert werden, um eine markante Unterbrechung im Muster zu vermeiden.

3. Verfahren nach Anspruch 2, **dadurch gekennzeichnet, dass** die gesetzmässig Variation der Anfänge der bandförmigen Deckschicht einer Sinuslinie folgt.

4. Verfahren nach einem der Ansprüche 1 bis 3, **dadurch gekennzeichnet, dass** die nicht durch das Wachs abgedeckten Stellen des mit einer bandförmigen Deckschicht beschichteten Siebes - der Beschichtung nachfolgend - im gleichen Arbeitsgang belichtet werden.

5. Vorrichtung zum Beschichten eines feinmaschigen Siebes - das mit einer unbelichteten Photoemulsionsschicht versehen ist und auf dem diejenigen Stellen, die nicht zu belichten sind, musterbedingt mit einer lichtundurchlässigen Schicht abgedeckt werden, wobei die Abdeckschicht Wachs enthält und nach der Belichtung entfernt wird - mit einem Beschichter (20, 40), **dadurch gekennzeichnet, dass** der Beschichter (20, 40) einen Sprühkopf zum Aufbringen der Deckschicht in Bändern auf die Photoemulsionsschicht umfasst.

6. Vorrichtung nach Anspruch 5 mit Reitstöcken (3, 4) einer Anordnung zum Rotieren eines rohrförmigen Siebes (5) um seine Längsachse, **dadurch gekennzeichnet, dass** wenigstens der eine Reitstock (3, 4) mit einer Zuführung von Pressluft in den zylindrischen Hohlraum des rohrförmigen Siebes (5) ausgebildet ist.

7. Vorrichtung nach Anspruch 6, **dadurch gekennzeichnet, dass** eine Anzahl Stützen (6, 7, 8) mit je einer Auflageplatte (9) mit je einer kreissegmentförmiger Ausnehmung als Einlegehilfen und zur Ausrichtung des rohrförmigen Siebes (5) auf die Reitstöcke (3, 4) vorgesehen sind.

8. Vorrichtung nach Anspruch 5 **gekennzeichnet durch** eine Anzahl zeilen- und spaltenförmig angeordneter Stützköpfe (43) zur Halterung eines flachen Siebes (42).

9. Vorrichtung nach Anspruch 8 **dadurch gekennzeichnet, dass** einige der Stützköpfe (43) so ausgebildet und angeordnet sind, dass sie auch die Ausrichtung des Rahmens (41) des flachen Siebes (42) in den zwei Hauptrichtungen X- und Y- bewirken.

## Claims

1. Method for the production of a printing stencil by means of a fine-mesh screen which is provided with an unexposed photoemulsion layer and on which those locations which are not to be exposed are covered with an opaque layer according to a particular pattern, the covering layer containing wax and being removed after exposure, characterized in that the covering layer is applied to the photoemulsion layer in strips by means of a spray head.

2. Method according to Claim 1, characterized in that in the case of a cylindrical or tubular screen (5) the respective starts of the strip-shaped covering layer are varied for one revolution of the screen according to any law, in order to avoid a clear-cut interruption in the pattern.

3. Method according to Claim 2, characterized in that the variation, according to any law, in the start of the strip-shaped covering layer follows a sine line.

4. Method according to one of Claims 1 to 3, characterized in that the locations, not covered by the wax, of the screen coated with a strip-shaped covering layer are exposed - subsequent to the coating - in the same operation.

5. Apparatus for coating a fine-mesh screen - which is provided with an unexposed photoemulsion layer and on which those locations which are not to be exposed are covered with an opaque layer according to a particular pattern, the covering layer containing wax and being removed after exposure - having a coater (20, 40), characterized in that the coater (20, 40) comprises a spray head for applying the covering layer in strips to the photoemulsion layer.

6. Apparatus according to Claim 5 having tailstocks (3, 4) of an arrangement for rotating a tubular screen (5) about its longitudinal axis, characterized in that at least one tailstock (3, 4) is designed with a feed of compressed air into the cylindrical cavity of the tubular screen (5).

7. Apparatus according to Claim 6, characterized by the provision of a number of stays (6, 7, 8), each with a bearing plate (9), each with a recess in the form of a segment of a circle, as insertion aids and for the purpose of aligning the tubular screen (5) with the tailstocks (3, 4).

8. Apparatus according to Claim 5, characterized by a number of supporting heads (43), arranged in rows and columns, for holding a flat screen (42).

9. Apparatus according to Claim 8, characterized in that some of the supporting heads (43) are designed and arranged such that they also align the frame (41) of the flat screen (42) in the two main directions of X and Y.

## Revendications

1. Procédé pour la fabrication d'un pochoir comprenant un tamis à mailles serrées qui est muni d'une couche d'émulsion photographique vierge et sur laquelle les endroits qui ne doivent pas être exposés sont recouverts, en fonction du gabarit, d'une couche imperméable à la lumière, dans lequel la couche de recouvrement contient de la cire et est éliminée après l'exposition, caractérisé en ce que la couche de recouvrement est appliquée en bandes au moyen d'une tête de pulvérisation sur la couche d'émulsion photographique.

2. Procédé selon la revendication 1, caractérisé en ce que, dans le cas d'un tamis cylindrique respectivement tubulaire (5), on fait varier de manière régulière les débuts respectifs de la couche de recouvrement en forme de bande pour une rotation du tamis pour éviter une interruption laissant une marque dans le gabarit.

3. Procédé selon la revendication 2, caractérisé en ce que la variation régulière des débuts de la couche de recouvrement en forme de bande suit une ligne sinusoïdale.

4. Procédé selon l'une quelconque des revendications 1 à 3, caractérisé en ce que les endroits du tamis enduit d'une couche de recouvrement en forme de bande non recouverts par la cire sont exposés - suite à l'enduction - au cours de la même opération.

5. Dispositif pour l'enduction d'un tamis à mailles serrées - qui est muni d'une couche vierge d'émulsion photographique et sur laquelle les endroits qui ne doivent pas être exposés sont recouverts, en fonction du gabarit, d'une couche imperméable à la lumière, la couche de recouvrement contenant de la cire et étant éliminée après l'exposition - comprenant un dispositif d'enduction (20, 40), caractérisé en ce que le dispositif d'enduction (20, 40) comprend une tête de pulvérisation pour appliquer la couche de recouvrement en bandes sur la couche d'émulsion photographique.

6. Dispositif selon la revendication 5, comprenant des contre-poupées (3, 4) d'un agencement pour la rotation d'un tmis tubulaire (5) autour de son axe longitudinal, caractérisé en ce qu'au moins la première contre-poupée (3, 4) est réalisée avec une amenée d'air comprimé dans l'espace creux cylindrique du tamis tubulaire (5).

7. Dispositif selon la revendication 6, caractérisé en ce qu'on prévoit une multitude de tubulures (6, 7, 8) comprenant respectivement une plaque d'appui (9) munie chacune d'un évidement en forme de segment de cercle pour favoriser l'insertion et pour aligner le tamis tubulaire (5) sur les contre-poupées (3, 4).

8. Dispositif selon la revendication 5, caractérisé par une multitude de têtes de support (43) disposées à l'horizontale et à la verticale pour le maintien d'un tamis plat (42).

9. Dispositif selon la revendication 8, caractérisé en ce qu'un certain nombre des têtes de support (43) sont réalisées et disposées de telle sorte qu'elles effectuent également l'alignement du cadre (41) du tamis plat (42) dans les deux directions principales X et Y.
